# EUROPEAN PATENT APPLICATION

(11) **EP 4 608 104 A1**
(43) Date of publication of application: **27.08.2025**
(21) Application number: 25158580.8
(22) Date of filing: 18.02.2025
(51) Int. Cl.: H10H 29/851

(54) **WHITE LIGHT EMITTING DEVICE AND DISPLAY APPARATUS**

(30) Priority: 22.02.2024 KR 20240025759
(71) Applicant: Samsung Electronics Co., Ltd., Suwon-si, Gyeonggi-do 16677 (KR)
(72) Inventor: YUN, Jeongeun, 16677 Suwon-si, Gyeonggi-do (KR); KIM, Seongmin, 16677 Suwon-si, Gyeonggi-do (KR); PARK, Jongwon, 16677 Suwon-si, Gyeonggi-do (KR); OH, Jeongrok, 16677 Suwon-si, Gyeonggi-do (KR); WON, Hyongsik, 16677 Suwon-si, Gyeonggi-do (KR); YOON, Chulsoo, 16677 Suwon-si, Gyeonggi-do (KR)
(74) Representative: Kuhnen & Wacker Patent- und Rechtsanwaltsbüro PartG mbB

(57) **Abstract**

A white light emitting device (100) comprising a first light emitting diode (LED) chip (30A) emitting light having a peak wavelength in a range of 425 nm to 455 nm; a second LED chip (30B) emitting light having a peak wavelength in a range of 460 nm to 470 nm; a first wavelength conversion material (55G) disposed at a traveling path of light emitted from the first and second LED chips (30B) and converting a portion of the emitted light into first light; and a second wavelength conversion material (55R) disposed at the traveling path of the light emitted from the first and second LED chips (30B) and converting a portion of the emitted light into second light, wherein the first light, the second light, the emitted light from each of the first and second LED chips (30B) form a white light as an output of the white light emitting device (100).

## Description

### BACKGROUND

The present inventive concept relates to a white light emitting device and a display apparatus.

In general, white light emitting devices may be manufactured by combining blue light emitting diode (LED) chips with various wavelength conversion materials. White light emitting devices have been used as light sources of backlights for display apparatuses. These LED display apparatuses have been widely used in various fields, such as monitors for learning, tablet PCs, gaming monitors, and vehicle displays.

### SUMMARY

An aspect of the present inventive concept is to provide a white light emitting device having an excellent (or wide) color gamut, while reinforcing the conditions of human-oriented lighting.

Another aspect of the present inventive concept is to provide a display apparatus having an excellent color gamut, while reinforcing the conditions of human-oriented lighting.

According to an aspect of the present disclosure, a white light emitting device includes a first light emitting diode (LED) chip emitting light having a peak wavelength in a range of 425 nm to 455 nm, a second LED chip emitting light having a peak wavelength in a range of 460 nm to 470 nm, a first wavelength conversion material disposed at a traveling path of light emitted from the first and second LED chips and converting a portion of the emitted light into first light, and a second wavelength conversion material disposed at the traveling path of the light emitted from the first and second LED chips and converting a portion of the emitted light into second light. The first light, the second light, the emitted light from each of the first and second LED chips form a white light as an output of the white light emitting device. The first light has a peak wavelength in a range of 520 nm to 550 nm, and the second light has a peak wavelength in a range of 610 nm to 650 nm and a full width at half maximum (FWHM) of 50 nm or less. The white light of the white light emitting device has a melanopic ratio (M/P ratio) of 1.3 or more and has a color gamut with a coverage rate of 90% or more with respect to a DCI-P3 color gamut standard.

According to an aspect of the present disclosure, a white light emitting device includes a first light emitting diode (LED) chip emitting light having a peak wavelength in a range of 425 nm to 455 nm, a second LED chip emitting light having a peak wavelength in a range of 460 nm to 470 nm, a first wavelength conversion material disposed at a traveling path of light emitted from the first and second LED chips and converting a portion of the emitted light into first light having a peak wavelength in a range of 520 nm to 550 nm, and a second wavelength conversion material disposed at the traveling path of the light emitted from the first and second LED chips and converting a portion of the emitted light into second light having a peak wavelength in a range of 610 nm to 650 nm. The first light, the second light, the emitted light from each of the first and second LED chips form a white light as an output of the white light emitting device. The second wavelength conversion material includes a fluoride phosphor of which a composition formula is AₓMF_{y}:Mn⁴⁺, in which A is at least one selected from Li, Na, K, Rb, and Cs, M is at least one selected from Si, Ti, Zr, Hf, Ge, and Sn, and the composition formula satisfies 2≤x≤3 and 4≤y≤7. A blue light hazard (BLH) value of the white light of the white light emitting device is 0.0018 W/m² or less. The white light has a color gamut with a coverage rate of 90% or more with respect to a DCI-P3 color gamut standard.

According to an aspect of the present disclosure, a display apparatus includes an image display panel having a color filter layer including red, green, and blue color filters, and a backlight unit disposed on a lower surface of the image display panel and having a plurality of light sources. Each of the plurality of light sources includes a white light emitting device including a first light emitting diode (LED) chip emitting light having a peak wavelength in a range of 425 nm to 455 nm, a second LED chip emitting light having a peak wavelength in a range of 460 nm to 470 nm, a first wavelength conversion material disposed at a traveling path of light emitted from the first and second LED chips and converting a portion of the emitted light into first light, and a second wavelength conversion material disposed at the traveling path of the light emitted from the first and second LED chips and converting a portion of the emitted light into second light. The first light has a peak wavelength in a range of 520 nm to 550 nm, and the second light has a peak wavelength in a range of 610 nm to 650 nm and a full width at half maximum (FWHM) of 50 nm or less. The first light, the second light, the emitted light from each of the first and second LED chips form a white light as an output of the white light emitting device. The white light from each of the plurality of light sources has a melanopic ratio of 1.3 or more. A color gamut of light emitted from the image display panel has a coverage rate of 90% or more with respect to a DCI-P3 color gamut standard.

According to an aspect of the present disclosure, a white light emitting device includes a package substrate, a main body having an opening exposing a portion of an upper surface of the package substrate, a first blue light emitting diode (LED) chip disposed on the portion of the upper surface of the package substrate and emitting a first blue light having a first peak wavelength, a second blue LED chip disposed on the portion of the upper surface of the package substrate and emitting a second blue light having a second peak wavelength different from the first peak wavelength, and a wavelength conversion portion disposed in the opening and covering the first blue LED chip and the second blue LED chip and generating a white light from the first blue light and the second blue light.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a schematic cross-sectional view illustrating a white light emitting device according to an example embodiment of the present inventive concept;
FIG. 2 is an emission spectrum of light emitted from a white light emitting device according to an example embodiment of the present inventive concept;
FIG. 3 is an emission spectrum of light emitted from white light emitting devices according to a specific example embodiment (Example 1) and a comparative example (Comparative Example 1) of the present inventive concept;
FIG. 4 is an emission spectrum of light emitted from white light emitting devices according to a specific example embodiment (Example 2) and comparative examples (Comparative Examples 2A and 2B) of the present inventive concept;
FIGS. 5A and 5B are cross-sectional views of an LED chip applicable to a white light emitting device according to an example embodiment of the present inventive concept;
FIGS. 6A and 6B are a schematic cross-sectional view and a schematic perspective view, respectively, illustrating a white light emitting device according to an example embodiment of the present inventive concept;
FIG. 7 is a schematic cross-sectional view illustrating a white light emitting device according to an example embodiment of the present inventive concept;
FIG. 8 is an emission spectrum of light emitted from a white light emitting device according to an example embodiment of the present inventive concept;
FIG. 9 is a block diagram of a display apparatus according to an example embodiment of the present inventive concept;
FIG. 10 is a schematic cross-sectional view of a display apparatus according to an example embodiment of the present inventive concept; and
FIG. 11 is a schematic exploded perspective view of a display apparatus according to an example embodiment of the present inventive concept.

### DETAILED DESCRIPTION

Hereinafter, example embodiments of the present inventive concept are described with reference to the accompanying drawings.

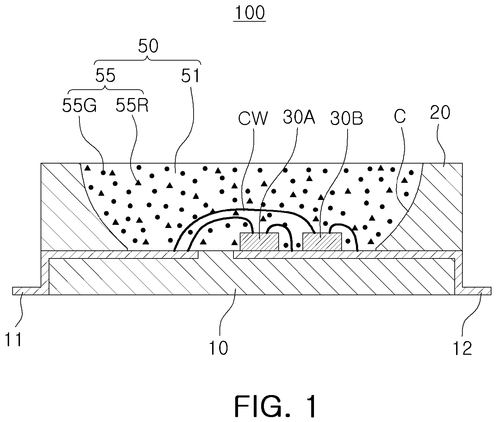

FIG. 1 is a schematic cross-sectional view illustrating a white light emitting device according to an example embodiment of the present inventive concept.

Referring to FIG. 1, a white light emitting device 100 according to the present example embodiment may include a package substrate 10, first and second blue light emitting diode (LED) chips 30A and 30B disposed on the package substrate 10, and a wavelength conversion portion 50. The white light emitting device 100 may further include a pair of lead frames 11 and 12 electrically connected to the first and second blue LED chips 30A and 30B, a sidewall reflector 20 having a concave portion C, and a conductive wire CW connecting the first and second blue LED chips 30A and 30B to the lead frames 11 and 12.

For example, the package substrate 10 may be molded from an opaque resin or a resin having high reflectivity, may facilitate an injection process, and may include a polymer resin including highly reflective powder. In addition, the package substrate 10 may be formed of ceramic, in which case heat dissipation may be facilitated. In some example embodiments, the package substrate 10 may be a printed circuit board on which an interconnection pattern replacing the lead frames 11 and 12 is formed.

The sidewall reflector 20 may be disposed on the package substrate 10, and the first and second blue LED chips 30A and 30B may be arranged on the package substrate 10 within the concave portion C and electrically connected to the lead frames 11 and 12. The sidewall reflector 20 may have a cup shape to improve light reflection efficiency, but is not limited thereto. In some example embodiments, the sidewall reflector 20 may be provided as a main body integrated with the package substrate 10 as a portion of a main body. For example, the sidewall reflector 20 and the package substrate 10 may be formed of the same material (e.g., a resin including highly reflective white powder) through the same process (e.g., injection molding).

The first blue LED chip 30A and the second blue LED chip 30B employed in the present example embodiment may each be configured to emit blue light having different wavelengths. By combining a first blue light and a second blue light having two different wavelengths, the amount of light in the wavelength band therebetween may be reduced. In some example embodiments, the first blue LED chip 30A may be configured to emit first blue light having a peak wavelength in a range of 425 nm to 455 nm, and the second blue LED chip 30B may be configured to emit second blue light having a peak wavelength in a range of 460 nm to 470 nm.

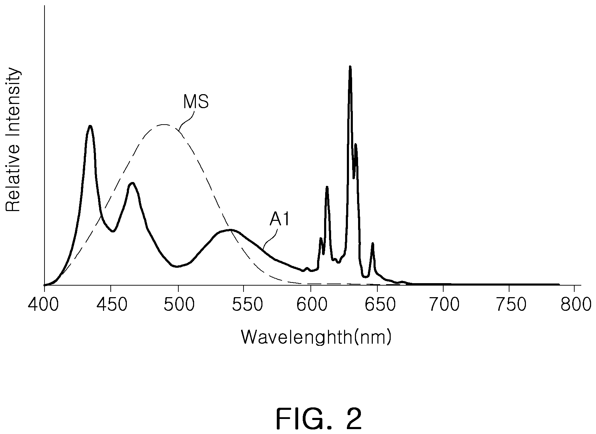

FIG. 2 is an emission spectrum of light emitted from a white light emitting device according to an example embodiment of the present inventive concept.

As illustrated in FIG. 2, in the emission spectrum of final light, a blue band in which blue light hazard (BLH) is concentrated, that is, a melanopic sensitive band (MS), is adjusted to reduce harmfulness of the white light emitting device 100 due to BLH. In addition, it may help improve concentration by suppressing the secretion of melatonin, which affects enzymes involved in biological rhythms and concentration. In the emission spectrum A1 illustrated in FIG. 2, the blue light wavelength of the first and second blue LED chips may be designed as described above so that the band including, especially, 430 nm to 450 nm, which is the peak band of BLH in the melanopic sensitive band (MS), is reduced.

As such, the white light emitting device 100 according to the present example embodiment minimizes BLH by introducing first and second blue LED chips 30A and 30B each emitting blue light having different wavelengths, while suppressing secretion of melatonin hormone, thereby helping to improve concentration. For example, the final light of the white light emitting device 100 may have a BLH value of 0.0018 W/m² or less. Meanwhile, a melanopic (M/P) ratio of the final light may be 1.3 or more (see Tables 1 and 2 below). Accordingly, the white light emitting device 100 according to the present example embodiment may be beneficially used as a human-oriented display light source.

The wavelength conversion portion 50 may be disposed on an optical path of the first and second blue LED chips 30A and 30B and may include a plurality of wavelength conversion materials 55. In the present example embodiment, the plurality of wavelength conversion materials 55 may include a first wavelength conversion material 55G converting a portion of the first blue light and a portion of the second blue light into first light having a peak wavelength in a range of 520 nm to 550 nm and a second wavelength conversion material 55R converting a portion of the first blue light and a portion of the second blue light into second light having a peak wavelength in a range of 610 nm to 650 nm.

For example, the first wavelength conversion material 55G may include at least one of (Ba,Sr)₂SiO₄:Eu and β-SiAlON:Eu. The second wavelength conversion material 55R employed in the present example embodiment may be configured so that the converted second light has a full width at half maximum (FWHM) of 50 nm or less. In this manner, by introducing the second wavelength conversion material having a smaller FWHM than other general phosphors, an excellent color gamut may be guaranteed, while a high luminous flux is maintained. For example, the second wavelength conversion material 55R may include a fluoride phosphor expressed by the composition formula AₓMF_{y}:Mn⁴⁺. Here, A is at least one selected from Li, Na, K, Rb, and Cs, M is at least one selected from Si, Ti, Zr, Hf, Ge, and Sn, and the composition formula satisfies 2≤x≤3 and 4≤y ≤7. In some example embodiments, the second wavelength conversion material 55R may be a K₂SiF₆:Mn⁴⁺ phosphor.

Therefore, the white light emitting device 100 according to the present example embodiment may be used as an excellent display light source. Specifically, the final light of the white light emitting device 100 may have a wide color gamut with a coverage rate of 90% or more with respect to the Digital Cinema Initiatives - Protocol 3 (DCI-P3) color gamut standard. In addition, the luminous efficacy of radiation (LER) of the final light may be 220 W/m² or more (see Tables 1 and 2 below).

The white light emitting device 100 according to the present example embodiment may be configured such that the first and second light having different wavelengths excited by the first and second blue light generated by the first and second blue LED chips 30A and 30B to be converted are combined with unconverted portions of the first and second blue light to finally emit white light.

These first and second wavelength conversion materials 55G and 55R may be mixed in an appropriate amount so that the final light from the white light emitting device 100 has a desired white light depending on the conversion wavelength and conversion efficiency. The CIE 1931 color coordinates of the final light according to the present example embodiment may be (0.270<X<0.280, 0.235<Y<0.245). In some example embodiments, the color temperature of the final light may be 19000 K or greater (see Tables 1 and 2 below).

In some example embodiments, the second wavelength conversion material 55R may further include at least one of (Sr,Ca)AlSiN₃:Eu and CaAlSiN₃:Eu in addition to the fluoride phosphor having a small FWHM. In the present example embodiment, a plurality of wavelength conversion materials 55G and 55R may be dispersed in a transparent resin 51 of the wavelength conversion portion 50. For example, the transparent resin 51 may be formed of epoxy, silicone, modified silicone, urethane resin, oxetane resin, acrylic, polycarbonate, polyimide, or a combination thereof. In some example embodiments, the first and second wavelength conversion materials 55G and 55R may not be dispersed in the transparent resin 51, and instead, the first and second wavelength conversion materials 55G and 55R may be directly applied to the surfaces of the first and second blue LED chips 30A and 30B or may be disposed on the transparent resin 51 as a film including a wavelength conversion material.

Hereinafter, in order to confirm the desirable requirements of the white light emitting device according to the present example embodiment, white light emitting devices were prepared according to the conditions in Table 1 below, and the white light characteristics of each white light emitting device were measured (see Table 2 below).

The white light emitting devices according to the comparative examples and examples below were commonly manufactured to have a structure similar to the white light emitting device illustrated in FIG. 1, β-SiAlON:Eu having a peak wavelength of 540 nm to 545 nm was used as the first wavelength conversion material, and other conditions (e.g., a mixture ratio of the first and second wavelength conversion materials, etc.) were appropriately designed to emit almost the same white light. Each white light was designed to satisfy the CIE 1931 color coordinates (0.270<X<0.280, 0.235<Y<0.245). As illustrated in Table 1 below, the Commission Internationale de l'Éclairage (CIE) 1931 color coordinates of the examples are (0.274, 0.240), and the comparative examples may have similar color coordinates, although there are some differences. The color temperature of final light in each example embodiment may be 19000 K or more.

In each of the comparative examples 1, 2A, and 2B and examples 1A to 1G and 2A to 2G, the two blue LED chips had different peak wavelength conditions. Specifically, in each example embodiment, the emission wavelength of the first blue LED chip varied in the range of 420 nm to 455 nm (varying in units of 5 nm), and the emission wavelength of the second blue LED chip was set to 460 nm and 465 nm. In Comparative Examples 2A and 2B, the emission wavelength of the first blue LED chip was set to 425 nm, and the emission wavelength of the second blue LED chip were set to 460 nm and 465 nm. However, in Comparative Example 1, the emission wavelength of the two blue LED chips was set to the same peak wavelength (450 nm).

Meanwhile, in the examples, K₂SiF₆:Mn⁴⁺ was used as the second wavelength conversion material. In Comparative Example 1, the same K₂SiF₆:Mn⁴⁺ was used, but in Comparative Examples 2A and 2B, CaAlSiN₃:Eu was used.

**[Table 1]**

| Classifica tion | Type of second wavelength conversion material | Peak wavelength | | Feature of final light | | |
|---|---|---|---|---|---|---|
| | | First LED chip (nm) | Second LED chip (nm) | CIE x | CIE y | CCT(K) |
| Comparat ive Example 1 | K₂SiF₆:Mn⁴⁺ | 450 | 450 | 0.253 | 0.228 | |
| Comparat ive Example 2A | CaAlSiN₃:Eu | 425 | 465 | 0.268 | 0.246 | 19912 |
| Comparat ive Example 2B | CaAlSiN₃:Eu | 425 | 460 | 0.268 | 0.235 | 28422 |
| Example 1A | K₂SiF₆:Mn⁴⁺ | 425 | 460 | 0.274 | 0.240 | 19920 |
| Example 1B | | 430 | 460 | 0.274 | 0.240 | 19920 |
| Example 1C | | 435 | 460 | 0.274 | 0.240 | 19920 |
| Example 1D | | 440 | 460 | 0.274 | 0.240 | 19920 |
| Example 1E | | 445 | 460 | 0.274 | 0.240 | 19921 |
| Example 1F | | 450 | 460 | 0.274 | 0.240 | 19920 |
| Example 1G | | 455 | 460 | 0.274 | 0.240 | 19920 |
| Example 2A | K₂SiF₆:Mn⁴⁺ | 425 | 465 | 0.274 | 0.240 | 19920 |
| Example 2B | | 430 | 465 | 0.274 | 0.240 | 19920 |
| Example 2C | | 435 | 465 | 0.274 | 0.240 | 19920 |
| Example 2D | | 440 | 465 | 0.274 | 0.240 | 19920 |
| Example 2E | | 445 | 465 | 0.274 | 0.240 | 19920 |
| Example 2F | | 450 | 465 | 0.274 | 0.240 | 19920 |
| Example 2G | | 455 | 465 | 0.274 | 0.240 | 19920 |

As such, Comparative Example 1 are different from Examples in that the first and second blue LED chips have the same emission wavelength, and Comparative Examples 2A and 2B are different from Examples in that a red phosphor other than K₂SiF₆:Mn⁴⁺ is used.

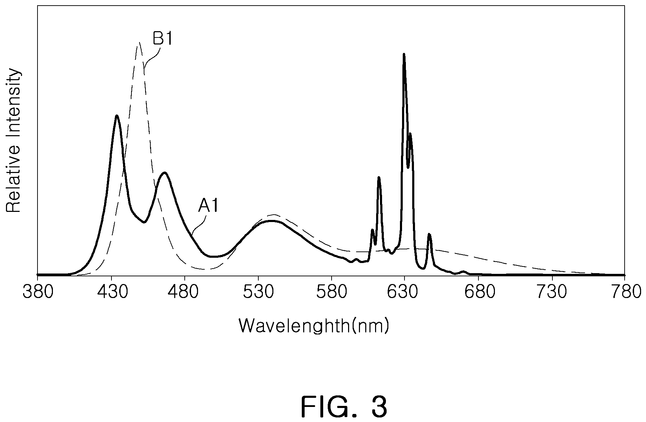

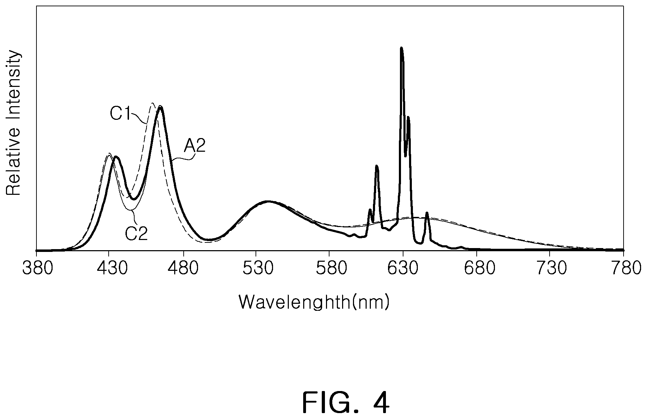

FIG. 3 is an emission spectrum of light emitted from white light emitting devices according to an example (Example 2C: A1) and a comparative example (Comparative Example 1: B1) of the present inventive concept, and FIG. 4 is an emission spectrum of light emitted from the white light emitting devices according to an example (Example 1D: A2) and comparative examples (Comparative Examples 2A and 2B: C1 and C2, respectively).

The M/P ratio and BLH characteristics of the final white light of the white light emitting device according to Table 1 above, as well as the improvement rate (Ref.: Comparative Example 2A), luminous efficacy of radiation (LER) as an indicator of light output and the improvement rate, and DCI coverage rate were measured and are illustrated in Table 2 below.

**[Table 2]**

| Classific ation | M/P ratio | M/P impro vemen t rate (%) | BLH/lm (W/m²) | BLH improv ement rate (%) | LER (W/m²) | LER improv ement rate (%) | DCI coverag e rate (%) |
|---|---|---|---|---|---|---|---|
| Compara tive Example 1 | 1.15 | 83% | 0.00183 | 109% | 230 | 108% | 91% |
| Compara tive Example 2A | 1.38 | 100% | 0.001678 | 100% | 213 | 100% | 89% |
| Compara tive Example 2B | 1.33 | 96% | 0.001800 | 107% | 210 | 98% | 92% |
| Example 1A | 1.30 | 94% | 0.001719855 | 102% | 236.6 | 111% | 95% |
| Example 1B | 1.30 | 94% | 0.001719855 | 102% | 236.6 | 111% | 95% |
| Example 1C | 1.30 | 94% | 0.001651405 | 98% | 242.3 | 114% | 95% |
| Example 1D | 1.32 | 95% | 0.001598713 | 95% | 245.7 | 115% | 95% |
| Example 1E | 1.35 | 98% | 0.001560139 | 93% | 247.1 | 116% | 95% |
| Example 1F | 1.39 | 101% | 0.001532019 | 91% | 246.7 | 116% | 95% |
| Example 1G | 1.44 | 105% | 0.001509794 | 90% | 245.0 | 115% | 95% |
| Example 2A | 1.42 | 103% | 0.001721748 | 103% | 229.6 | 108% | 92% |
| Example 2B | 1.42 | 103% | 0.001721748 | 103% | 229.6 | 108% | 92% |
| Example 2C | 1.41 | 102% | 0.001649068 | 98% | 235.7 | 110% | 93% |
| Example 2D | 1.43 | 103% | 0.001593369 | 95% | 239.3 | 112% | 93% |
| Example 2E | 1.46 | 105% | 0.001552641 | 93% | 240.7 | 113% | 93% |
| Example 2F | 1.50 | 109% | 0.001522885 | 91% | 240.4 | 113% | 92% |
| Example 2G | 1.56 | 113% | 0.001499221 | 89% | 238.5 | 112% | 90% |

In terms of M/P ratio and BLH characteristics, it can be seen that, Examples 1F and 1G and Examples 2A to 2G were improved by 1 to 13%, and Examples 1A to 1E were also clearly improved compared to Comparative Example 1. Specifically, the M/P ratio of white light according to Examples was 1.35 or more, and the BLH value appeared to be 0.0018 W/m² or less.

Meanwhile, in terms of luminous flux and a color reproduction range, it can be seen that, the DCI coverage rate according to Examples was not only as high as 90% or more (95% in some examples), but also the luminous flux (LER) was improved by 10% or more, compared to Comparative Example 2A. Specifically, the LER of white light according to Examples may be 220 W/m² or more. In particular, in terms of DCI coverage rate, it can be seen that, when K₂SiF₆:Mn⁴⁺ was used as the second wavelength conversion material under the same conditions (Comparative Example 2A vs. Example 2A, Comparative Example 2B vs. Example 1A), each increased by about 3%.

As such, the white light emitting device according to the present example embodiments has a high luminous flux, while maintaining a high color reproduction range, and thus may be usefully used as an excellent display light source.

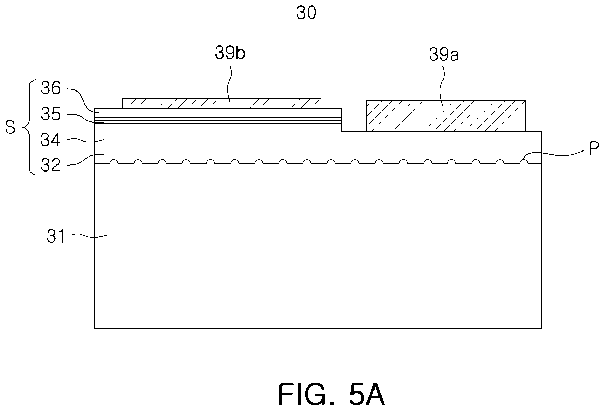

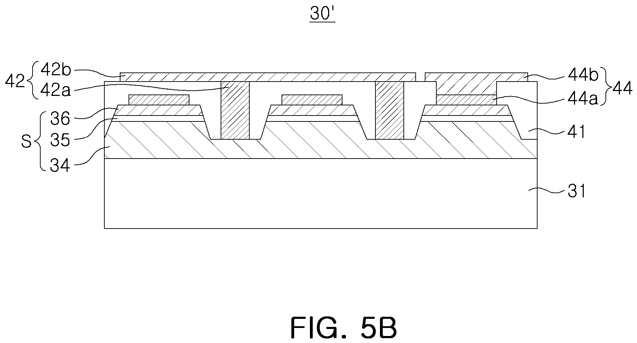

FIGS. 5A and 5B are cross-sectional views of an LED chip applicable to a white light emitting device according to an example embodiment of the present inventive concept. At least one of the LED chips 30 and 30' illustrated in FIGS. 5A and 5B may be used as the first and second blue LED chips 30A and 30B of the white light emitting device 100 described above.

Referring to FIG. 5A, the LED chip 30 employed in the present example embodiment includes a substrate 31 and a semiconductor stack S disposed on the substrate 31. The semiconductor stack S may include a first conductivity-type semiconductor layer 34, an active layer 35, and a second conductivity-type semiconductor layer 36 sequentially disposed on the substrate 31. A buffer layer 32 may be additionally disposed between the substrate 31 and the first conductivity-type semiconductor layer 34.

The substrate 31 may be an insulating substrate, such as sapphire. However, the present inventive concept is not limited thereto, and the substrate 31 may be a conductive or semiconductor substrate. For example, the substrate 31 may be SiC, Si, MgAl₂O₄, MgO, LiAlO₂, LiGaO₂, or GaN. Irregularities P may be formed on an upper surface of the substrate 31. The irregularities P may improve the quality of a grown single crystal, while improving light extraction efficiency.

The buffer layer 32 may include undoped InₓAl_{y}Ga_{1-x-y}N (0≤x≤1, 0≤y≤1). For example, the buffer layer 32 may be GaN, AlN, AlGaN, or InGaN. If necessary, multiple layers may be combined or the composition may be gradually changed to be used.

The first conductivity-type semiconductor layer 34 may be a nitride semiconductor satisfying N-type InₓAl_{y}Ga_{1-x-y}N (0≤x<1, 0≤y<1, 0≤x+y<1), and the N-type impurity may be Si. For example, the first conductivity-type semiconductor layer 34 may include N-type GaN. The second conductivity-type semiconductor layer 36 may be a nitride semiconductor layer of P-type InₓAl_{y}Ga_{1-x-y}N (0≤x<1, 0≤y<1, 0≤x+y<1), and the P-type impurity may be Mg. For example, the second conductivity-type semiconductor layer 36 may be implemented as a single-layer structure, but, as in this example, may have a multilayer structure having different compositions.

The active layer 35 may have a multiple quantum well (MQW) structure in which quantum well layers and quantum barrier layers are alternately stacked. For example, the quantum well layer and the quantum barrier layer may be InₓAl_{y}Ga_{1-x-y}N (0≤x≤1, 0≤y≤1, 0≤x+y≤1) having different compositions. In a specific example, the quantum well layer may be InₓGa₁₋ₓN (0<x≤1), and the quantum barrier layer may be GaN or AlGaN. A thickness of the quantum well layer and the quantum barrier layer may each range from 1 nm to 50 nm. The active layer 35 is not limited to a multi-quantum well structure and may be a single quantum well structure.

First and second electrodes 39a and 39b may be disposed on a mesa-etched region of the first conductivity-type semiconductor layer 34 and the second conductivity-type semiconductor layer 36, respectively, to be located on the same surface (a first surface). The first electrode 39a may include, but is not limited to, materials, such as Ag, Ni, Al, Cr, Rh, Pd, Ir, Ru, Mg, Zn, Pt, and Au, and may be employed as a structure of a single layer or two layers. In some example embodiments, the second electrode 39b may be a transparent electrode, such as transparent conductive oxide or transparent nitride, or may include graphene. The second electrode 39b may include at least one of Al, Au, Cr, Ni, Ti, and Sn.

Referring to FIG. 5B, the LED chip 30' according to the present example embodiment may be understood as including a semiconductor stack S similar to the LED chip 30 illustrated in FIG. 5A, except for the electrode structure and a related structure thereof. Unless otherwise stated, the description of the components of the present example embodiment may refer to the description of the same or similar components as the LED chip 30 illustrated in FIG. 5A.

The LED chip 30' includes first and second electrodes 42 and 44 connected to the first and second conductivity-type semiconductor layers 34 and 36, respectively. The first electrode 42 may include a connection electrode portion 42a connected to the first conductivity-type semiconductor layer 34 through the second conductivity-type semiconductor layer 36 and the active layer 35 and a first electrode pad 42b connected to the connection electrode portion 42a. The connection electrode portion 42a may have a structure, such as a conductive via. The connection electrode portion 42a may be surrounded by an insulating portion 41 and electrically separated from the active layer 35 and the second conductivity-type semiconductor layer 36. The connection electrode portion 42a may be disposed in a region in which the semiconductor stack S is etched. The number, shape, and pitch of the connection electrode portion 42a or a contact area with the first conductivity-type semiconductor layer 34 of the connection electrode portions 42a may be appropriately designed so that contact resistance is lowered. In addition, the connection electrode portions 42a may be arranged in rows and columns on the semiconductor stack S to improve current flow. The second electrode 44 may include an ohmic contact layer 44a and a second electrode pad 44b on the second conductivity-type semiconductor layer 36.

The connection electrode portion 42a and the ohmic contact layer 44a may include a single-layer or multilayer structure formed of a conductive material having ohmic characteristics with the first and second conductivity-type semiconductor layers 34 and 36, respectively. For example, the connection electrode portion 42a and the ohmic contact layer 44a may be formed through a process, such as depositing or sputtering one or more of metals, such as Ag, Al, Ni, Cr, and transparent conductive oxide (TCO) such as ITO.

The first and second electrode pads 42b and 44b may be respectively connected to the connection electrode portion 42a and the ohmic contact layer 44a and may function as external terminals of the LED chip 30'. For example, the first and second electrode pads 42b and 44b may be Au, Ag, Al, Ti, W, Cu, Sn, Ni, Pt, Cr, NiSn, TiW, AuSn, or a eutectic metal thereof.

The first and second electrodes 42 and 44 may be arranged in the same direction and may be mounted on a lead frame, etc. in a so-called flip chip form. Meanwhile, the two electrodes 42 and 44 may be electrically separated from each other by an insulating portion 41. The insulating portion 41 may be formed of any material having electrically insulating properties. Although any material having electrically insulating properties may be used as the insulating portion 41, but a material having a low light absorption rate may be used. For example, silicon oxide or silicon nitride may be used. If necessary, a light-reflective structure may be formed by dispersing light-reflective powder particles in a light-transmissive material. In an embodiment, the insulating portion 41 may be a multilayer reflective structure in which a plurality of insulating films having different refractive indices are alternately stacked. For example, this multilayer reflective structure may be a distributed Bragg reflector (DBR) in which a first insulating film having a first refractive index and a second insulating film having a second refractive index are alternately stacked.

In the multilayer reflective structure, a plurality of insulating films having different refractive indices may be repeatedly stacked 2 to 100 times. For example, a plurality of insulating films may be repeatedly stacked 3 to 70 times, and further, may be repeatedly stacked 4 to 50 times. Each of the plurality of insulating films of the multilayer reflective structure may be an oxide or nitride, such as SiO₂, SiN, SiOₓN_{y}, TiO₂, Si₃N₄, Al₂O₃, TiN, and AlN, and a combination thereof. The refractive index of the first insulating film and the second insulating film may be determined in the range of about 1.4 to about 2.5 and may be a value smaller than the refractive index of the first conductivity-type semiconductor layer 34 and the refractive index of the substrate 31 or may be a value smaller than the refractive index of the first conductivity-type semiconductor layer 34 but larger than the refractive index of the substrate 31.

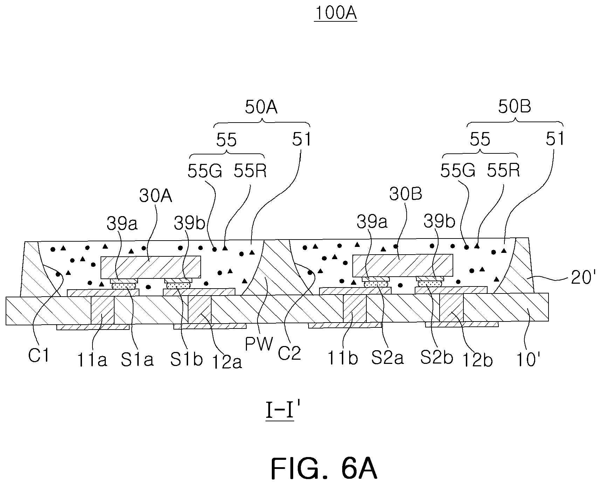

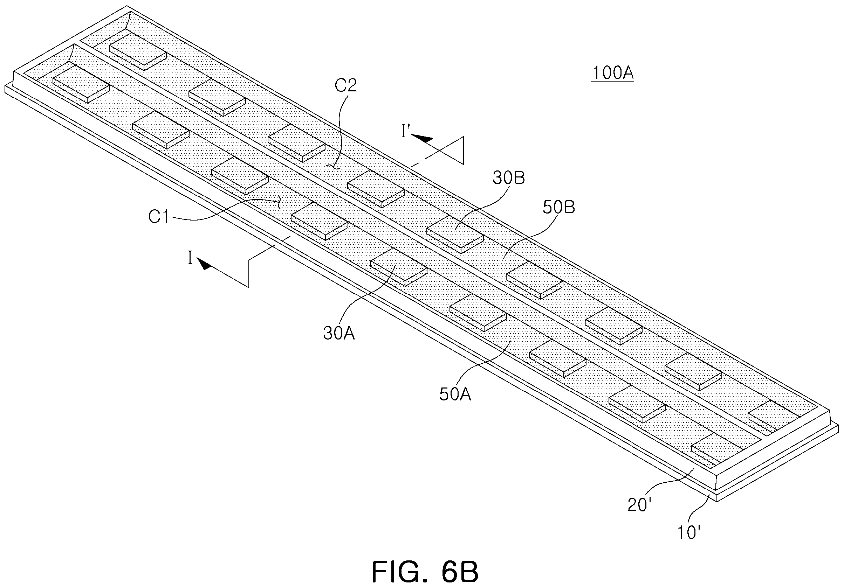

FIGS. 6A and 6B are a schematic cross-sectional view and a schematic perspective view, respectively, illustrating a white light emitting device according to an example embodiment of the present inventive concept. FIG. 6A is a cross-sectional view of the white light emitting device illustrated in FIG. 6B taken along line I-I'.

Referring to FIGS. 6A and 6B, a white light emitting device 100A according to the present example embodiment may be understood as being similar to the white light emitting device 100 illustrated in FIG. 1, except that main bodies of the package substrates 10' and sidewall reflector 20' have a first concave portion C1 and a second concave portion C2 extending in one direction, respectively, that a plurality of first and second blue LED chips 30A and 30B are flip-chip bonded side by side within the first and second concave portions C1 and C2, and that first and second wavelength conversion portions 50A and 50B are disposed in the first and second concave portions C1 and C2, respectively.

In the present example embodiment, the main body of the white light emitting device 100A includes a bar-shaped package substrate 10' and a sidewall reflector 20' disposed on the package substrate 10' and having the first concave portion C1 and the second concave portion C2 extending in one direction. In some example embodiments, the sidewall reflector 20' may be provided as a main body integrated with the package substrate 10'. For example, the sidewall reflector 20' and the package substrate 10' may be formed of the same reflective material through the same process (e.g., injection molding).

The package substrate 10' includes a pair of first electrode structures 11a and 12a disposed in a region corresponding to the first concave portion C1 and a pair of second electrode structures 11b and 12b disposed in a region corresponding to the second concave portion C2. Each of the first electrode structure 11a and 12a and the second electrode structure 11b and 12b employed in the present example embodiment may include an upper pad, a lower pad, and an interconnection portion connecting the upper and lower pads with each other.

In the present example embodiment, the first and second blue LED chips 30A and 30B may be arranged side by side in the first and second concave portions and may be flip-chip bonded to the first electrode structure 11a and 12a and the second electrode structure 11b and 12b, respectively. Specifically, the first blue LED chip 30A may be electrically connected to the first electrode structure 11a and 12a (in particular, the upper pad) through connecting conductors S1a and S1b, and the second blue LED chip 30B may be electrically connected to the second electrode structure 11b and 12b (in particular, the upper pad) through connecting conductors S2a and S2b. In an embodiment, the first and second concave portion is divided by a partition wall PW.

As described in the previous example embodiment, the first blue LED chip 30A and the second blue LED chip 30B may be configured to emit blue light having different wavelengths. In some example embodiments, the first blue LED chips 30A may be configured to emit first blue light having a peak wavelength in the range of 425 nm to 455 nm, and the second blue LED chips 30B may be configured to emit second blue light having a peak wavelength in the range of 460 nm to 470 nm. In this manner, the white light emitting device 100A may reduce the harmfulness caused by BLH by introducing the first and second blue light having different wavelengths. In addition, it may help improve concentration by suppressing the secretion of melatonin, which affects enzymes involved in biological rhythms and concentration.

In some example embodiments, the intensity ratio of the first and second blue light having different wavelengths may be adjusted by controlling the voltage applied to the first and second blue LED chips 30A and 30B through the first electrode structure 11a and 12a and the second electrode structure 11b and 12b, which are independently supplied with voltages. A voltage supplied to the first blue LED chip 30A via the first electrode structure 11a and 12a may be independently controlled from a voltage supplied to the second blue LED chip 30B via the second electrode structure 11b and 12b.

The first and second wavelength conversion portions 50A and 50B are disposed on optical paths of the first and second blue LED chips 30A and 30B, respectively, in the separated first and second concave portions C1 and C2. In the present example embodiment, each of the first and second wavelength conversion portions 50A and 50B may include a transparent resin 51 and a plurality of wavelength conversion materials 55 mixed in the transparent resin 51. The first and second wavelength conversion portions 50A and 50B may include the same type of wavelength conversion materials. For example, the wavelength conversion materials 55 may include a first wavelength conversion material 55G converting a portion of the emitted first and second blue light into first light having a peak wavelength in the range of 520 nm to 550 nm and a second wavelength conversion material 55R converting a portion of the first and second blue light into second light having a peak wavelength in the range of 610 nm to 650 nm.

For example, the first wavelength conversion material 55G may include at least one of (Ba,Sr)₂SiO₄:Eu and β-SiAlON:Eu. The second wavelength conversion material 55R employed in the present example embodiment may be configured so that the converted second light has an FWHM of 50 nm or less. For example, the second wavelength conversion material 55R may include a fluoride phosphor expressed by a composition formula AₓMF_{y}:Mn⁴⁺. Here, A is at least one selected from Li, Na, K, Rb, and Cs, M is at least one selected from Si, Ti, Zr, Hf, Ge, and Sn, and the composition formula satisfies 2≤x≤3 and 4≤y≤7. In some example embodiments, the second wavelength conversion material 55R may be a K₂SiF₆:Mn⁴⁺ phosphor.

The first and second wavelength conversion materials 55G and 55R may be mixed in an appropriate amount so that final light from the white light emitting device 100A has desired white light depending on the conversion wavelength and conversion efficiency. In an embodiment, the first and second wavelength conversion materials may be provided in particles. The CIE 1931 color coordinates of the final light according to the present example embodiment may be (0.270<X<0.280, 0.235<Y<0.245). In some example embodiments, the color temperature of the final light may be 19000 K or greater.

In addition, final light of the white light emitting device 100A may have a wide color gamut with a coverage rate of 90% or more with respect to the DCI-P3 color gamut standard. In addition, the luminous efficacy of radiation (LER) of the final light may be 220 W/m² or more.

Accordingly, the white light emitting device 100A according to the present example embodiment may be beneficially used as a human-oriented display light source.

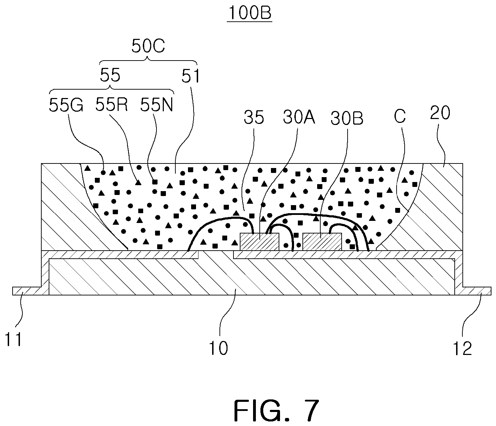

FIG. 7 is a schematic cross-sectional view illustrating a white light emitting device according to an example embodiment of the present inventive concept.

Referring to FIG. 7, a white light emitting device 100B according to the present example embodiment may be understood as being similar to the white light emitting device 100 illustrated in FIG. 1, except that the white light emitting device 100B further includes a near-infrared phosphor as a wavelength conversion material. In addition, unless otherwise stated, the components of the present example embodiment may be understood by referring to the description of the same or similar components of the white light emitting device 100 illustrated in FIG. 1.

A wavelength conversion portion 50C employed in the present example embodiment may include a near-infrared phosphor 55N along with the first and second wavelength conversion materials 55G and 55R described in the previous example embodiment. The near-infrared phosphor 55N employed in the present example embodiment may be configured to converting a portion of the light emitted from the first and second blue LED chips 30A and 30B, into light having a peak wavelength of 740 nm to 900 nm. In addition, the FWHM of the emission spectrum may be in the range of 90 nm to 110 nm. For example, the near-infrared phosphor 55N includes a phosphor expressed by a composition formula Ca(Al_{12-x-y},Ga_{y})O₁₉:xCr³⁺, in which x satisfies 0.1≤x≤0.3 and y satisfies 3 or more.

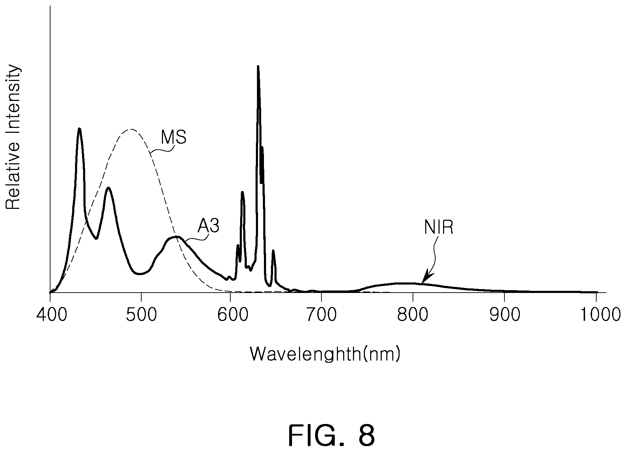

FIG. 8 illustrates an example of an emission spectrum of light emitted from the white light emitting device 100B according to an example embodiment of the present inventive concept. The white light emitting device 100B according to the present example embodiment may be understood as a form in which the near-infrared phosphor 55N is added to the white light emitting device 100 of FIG. 1, and the emission spectrum in FIG. 8 includes light (NIR) additionally converted by the near-infrared phosphor 55N in the emission spectrum of FIG. 2.

Referring to FIG. 8, light converted by the near-infrared phosphor 55N may be combined with second light (e.g., red light) by the second wavelength conversion material 55R to cover a significant portion of the adenosine triphosphate (ATP) action spectrum. Therefore, the white light emitting device 100B according to the present example embodiment may be provided as a human-oriented display light source module having an enhanced bioenergetic function in terms of the ATP action spectrum by the added near-infrared phosphor 55N.

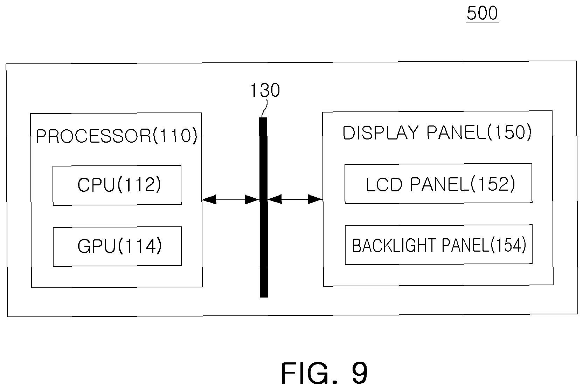

FIG. 9 is a block diagram of a display apparatus according to an example embodiment of the present inventive concept.

Referring to FIG. 9, the display apparatus 500 according to the present example embodiment may include a display panel 150 and a processor 110. The display panel 150 may include an LCD panel 152 and a backlight panel 154, and the backlight panel 154 may employ the white light emitting devices 100, 100A, and 100B according to the example embodiments described above as a light source module.

The display apparatus 500 may adjust transmittance of light that reaches the liquid crystal of the LCD panel 152 from the backlight panel 154 by controlling voltage and/or current.

The display apparatus 500 may reproduce a desired image by adjusting light transmittance of the liquid crystal. The display apparatus 500 may change the intensity of light output from the backlight panel 154. For example, the display apparatus 500 may increase or decrease the contrast ratio of the output image by adjusting the luminance and/or brightness of the LED light source included in the backlight panel 154. In an example embodiment, the display apparatus 500 may control color using a color filter and liquid crystal of the backlight panel 154.

The processor 110 may include an integrated circuit (IC) (e.g., a central processing unit (CPU)) 112 and/or a graphics processing unit (GPU) 114 for processing data based on one or more instructions, along with memory. For example, the CPU 112 may include an arithmetic and logic unit (ALU), a floating point unit (FPU), and a field programmable gate array (FPGA). The number of CPUs 112 may be one or more. For example, the CPU 112 may have a structure of a multi-core processor, such as dual core, quad core, or hexa core. For example, the GPU 114 may obtain an image to be output through the display panel 150 based on at least one application and/or system software executed by the CPU 112. In an example embodiment, the GPU 114 may generate a screen to be out put through the display panel 150 by controlling a display driver-IC (DDI) and/or graphics memory included in the display panel 150 through a communication bus 130.

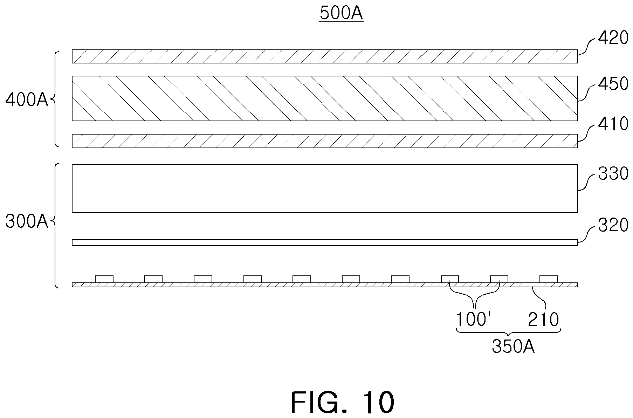

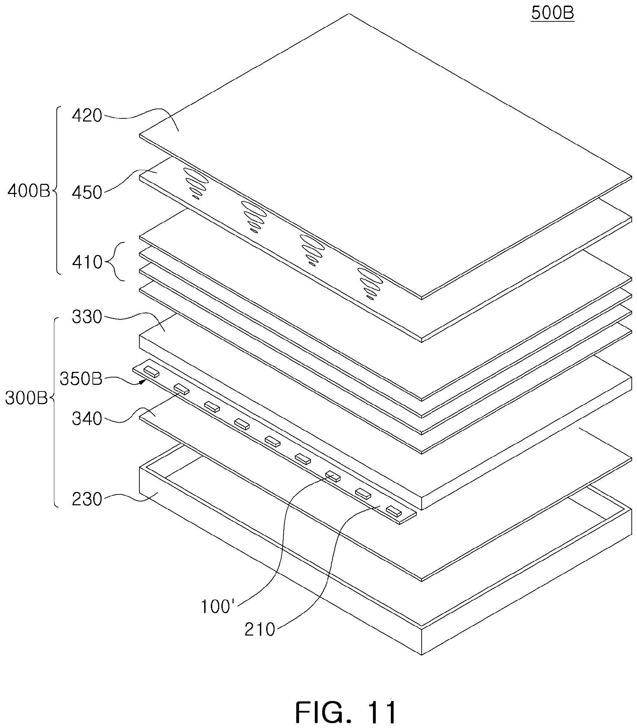

FIGS. 10 and 11 are structures of a display apparatus according to the present example embodiment and illustrate the arrangement relationship of each component including an LED light source based on a display panel structure.

FIG. 10 is a schematic cross-sectional view of a display apparatus (particularly, a display panel) according to an example embodiment of the present inventive concept.

Referring to FIG. 10, a display apparatus 500A according to the present example embodiment includes an image display panel 400A and a backlight unit 300A. The backlight unit 300A according to the present example embodiment is an example of a direct-type backlight unit. The backlight unit 300A may include a light guide plate 330, an light source module 350A disposed on a lower surface of the light guide plate 330, and a first optical sheet 320 between the light guide plate 330 and the light source module 350A. For example, the first optical sheet 320 may employ a combination of various optical members, such as a diffusion sheet and a polarizing sheet.

The light source module 350A may include a circuit board 210 and a plurality of LED light sources 100' mounted on the circuit board 210. The LED light source 100' may be the white light emitting device 100, 100A, or 100B according to the previous example embodiments. As illustrated in FIG. 10, the plurality of LED light sources 100' may be arranged in a plurality of rows and a plurality of columns on the circuit board 210.

The image display panel 400A may have a structure in which a second optical sheet 410, a liquid crystal layer 450, and a color filter layer 420 are sequentially disposed. The second optical sheet 410 may employ a combination of various optical members such as a diffusion sheet and a polarizing sheet. The color filter layer 420 may include a transparent substrate, a color filter, and a common electrode. The color filter layer 420 may include filters to selectively allow light having a specific wavelength, among the white light emitted from the backlight unit 300A, to pass therethrough. The liquid crystal layer 450 may include liquid crystals of which directions are rearranged by an electric field formed between the pixel electrode and the common electrode to adjust light transmittance. Light having adjusted light transmittance may pass through the color filter of the color filter layer 420 to display an image. The image display panel 400A may further include a driving circuit unit processing image signals. In this manner, white light emitted from the backlight unit 300A may pass through the second optical sheet 410 and the liquid crystal layer 450, and the transmitted white light may be incident on the color filter layer 420 to provide a desired color image.

FIG. 11 is a schematic exploded perspective view of a display apparatus according to an example embodiment of the present inventive concept.

Referring to FIG. 11, a display apparatus 500B according to the present example embodiment may include a backlight unit 300B and an image display panel 400B.

The backlight unit 300B employed in the present example embodiment may include a bottom case 230, a reflector 340, a light guide plate 330, and a light source module 350B provided on at least one side of the light guide plate 330. Similar to the previous example embodiment, the light source module 350B may include a circuit board 210 and a plurality of LED light sources 100' arranged on the circuit board 210. The plurality of LED light sources 100' may be the white light emitting device 100, 100A, or 100B according to the example embodiments described above. However, the LED light source 100' employed in the present example embodiment may be a side-view type light emitting device mounted so that a light emission window is located on the side.

The image display panel 400B employed in the present example embodiment may include a plurality of first optical sheets 410, a liquid crystal layer 450, and a color filter layer 420, similar to the image display panel 400A in the previous example embodiment. For example, the plurality of first optical sheets 410 may employ a combination of various optical members such as a diffusion sheet and a polarizing sheet.

As described above, the LED light source 100' employed in the present example embodiments may be provided as an excellent display light source which improves concentration by controlling the secretion of melatonin hormone and having a high color reproduction range.

By introducing the first and second blue LED chips having different wavelengths, it is possible to provide a light source for a display that may improve concentration by controlling the secretion of melatonin hormone, while lowering BLH. In addition, the display light source according to the example embodiment described above may ensure high luminous efficiency, while significantly improving a color gamut, by introducing the second wavelength conversion material (e.g., K₂SiF₆:Mn⁴⁺ phosphor) having a smaller FWHM than other general phosphors.

## Claims

1. A white light emitting device (100, 100A, 100B) comprising:
a first light emitting diode, LED, chip (30A) emitting light having a peak wavelength in a range of 425 nm to 455 nm;
a second LED chip (30B) emitting light having a peak wavelength in a range of 460 nm to 470 nm;
a first wavelength conversion material (55G) disposed at a traveling path of light emitted from the first and second LED chips (30B) and converting a portion of the emitted light into first light; and
a second wavelength conversion material (55R) disposed at the traveling path of the light emitted from the first and second LED chips (30B) and converting a portion of the emitted light into second light,
wherein the first light, the second light, the emitted light from each of the first and second LED chips (30B) form a white light as an output of the white light emitting device (100, 100A, 100B),
wherein the first light has a peak wavelength in a range of 520 nm to 550 nm, and the second light has a peak wavelength in a range of 610 nm to 650 nm and a full width at half maximum, FWHM, of 50 nm or less, and
wherein the white light of the white light emitting device (100, 100A, 100B) has a melanopic ratio, M/P ratio, of 1.3 or more and has a color gamut with a coverage rate of 90% or more with respect to a DCI-P3 color gamut standard.

2. The white light emitting device (100, 100A, 100B) of claim 1,
wherein the M/P ratio of the white light is 1.35 or more.

3. The white light emitting device (100, 100A, 100B) of claim 1 or 2,
wherein a blue light hazard, BLH, value of the white light is 0.0018 W/m² or less.

4. The white light emitting device (100, 100A, 100B) of any one of claims 1 to 3,
wherein a luminous efficacy of radiation, LER, of the white light is 220 W/m² or more.

5. The white light emitting device (100, 100A, 100B) of any one of claims 1 to 4,
wherein a color temperature of the white light is 19000 K or more.

6. The white light emitting device (100, 100A, 100B) of any one of claims 1 to 5,
wherein CIE 1931 color coordinates of the white light are 0.270<X<0.280 and 0.235<Y<0.245.

7. The white light emitting device (100, 100A, 100B) of any one of claims 1 to 6,
wherein the second wavelength conversion material (55R) includes a fluoride phosphor of which a composition formula is AₓMF_{y}:Mn⁴⁺, and
wherein A is at least one selected from Li, Na, K, Rb, and Cs, M is at least one selected from Si, Ti, Zr, Hf, Ge, and Sn, and the composition formula satisfies 2≤x≤3 and 4≤y≤7.

8. The white light emitting device (100, 100B) of any one of claims 1 to 7, further comprising:
a main body (20) having a concave portion (C) in which the first LED chip (30A) and the second LED chip (30B) are disposed.

9. The white light emitting device (100, 100B) of claim 8, further comprising:
a transparent resin (51) filling the concave portion (C),
wherein the first and second wavelength conversion materials (55R) are provided as particles and dispersed in the transparent resin (51).

10. The white light emitting device (100A) of any one of claims 1 to 7, further comprising:
a main body (20) having a first concave portion (C1) and a second concave portion (C2) in which the first LED chip (30A) and the second LED chip (30B) are respectively disposed.

11. The white light emitting device (100A) of claim 10, further comprising:
a transparent resin (51) filling each of the first and second concave portions (C2),
wherein the first and second wavelength conversion materials (55R) are provided as particles and are dispersed in the transparent resin (51) which is disposed in the first and second concave portions (C2).

12. The white light emitting device (100, 100A, 100B) of any one of claims 1 to 11, further comprising:
a near-infrared phosphor (55N) configured to converting a portion of the emitted light from the first and second LED chips (30B) into light having a peak wavelength of 740 nm to 900 nm.

13. The white light emitting device (100, 100A, 100B) of claim 12,
wherein the near-infrared phosphor (55N) includes a phosphor of which a composition formula is Ca(Al_{12-x-y},Ga_{y})O₁₉:xCr³⁺, in which x satisfies 0.1≤x≤0.3 and y satisfies 3 or more.

14. The white light emitting device (100, 100A, 100B) of any one of claims 1 to 13,
wherein the first wavelength conversion material (55G) includes at least one of (Ba,Sr)₂SiO₄:Eu and β-SiAlON:Eu.

15. The white light emitting device (100, 100A, 100B) of any one of claims 1 to 14,
wherein the second wavelength conversion material (55R) further includes at least one of (Sr,Ca)AlSiN₃:Eu and CaAlSiN₃:Eu.
